**Europäisches Patentamt**

**European Patent Office**

**Office européen des brevets**

(19)

(11) Veröffentlichungsnummer: **0 232 451**
**B1**

(12) # EUROPÄISCHE PATENTSCHRIFT

(45) Veröffentlichungstag der Patentschrift: **14.03.90**

(51) Int. Cl.⁵: **H 03 K 7/06,** G 01 R 21/00

(21) Anmeldenummer: **86108493.7**

(22) Anmeldetag: **21.06.86**

(54) Verfahren und Einrichtung zur Umwandlung eines elektrischen Signals in eine proportionale Frequenz.

(30) Priorität: **10.02.86 CH 517/86**

(43) Veröffentlichungstag der Anmeldung:
**19.08.87 Patentblatt 87/34**

(45) Bekanntmachung des Hinweises auf die
Patenterteilung:
**14.03.90 Patentblatt 90/11**

(84) Benannte Vertragsstaaten:
**AT BE CH DE FR GB IT LI NL SE**

(56) Entgegenhaltungen:
EP-A- 221 402
DE-A- 2 642 397
DE-B- 2 416 330
DE-B- 2 632 191

MESURES. REGULATION AUTOMATISME,
Band 50, Nr. 7, 2. Mai 1985, Seiten 69-71,73,
Paris, FR; J.P. FESTE: "Réhabilitons la
conversion tension-fréquence"

(73) Patentinhaber: **LGZ LANDIS & GYR ZUG AG**
**CH-6301 Zug (CH)**

(72) Erfinder: **Petr, Jan**
**Stolzengrabenstrasse 33**
**CH-6317 Oberwil (CH)**

(74) Vertreter: **Müller, Hans-Jürgen, Dipl.-Ing. et al**
**Müller, Schupfner & Gauger Lucile-Grahn-**
**Strasse 38 Postfach 80 13 69**
**D-8000 München 80 (DE)**

(56) Entgegenhaltungen:
**E.D.N. ELECTRICAL DESIGN NEWS, Band 30, Nr.**
**11, 16. Mai 1985, Seiten 153-162,164, Boston,**
**Massachusetts, US; J. WILLIAMS: "Design**
**techniques extend V/F-converter performance"**

**Beschreibung**

Die Erfindung bezieht sich auf ein Verfahren und eine Einrichtung zur Umwandlung eines elektrischen Signals in eine proportionale Frequenz gemäss dem Oberbegriff des Anspruchs 1 bzw. des Anspruchs 7.

Derartige Einrichtungen dienen zu Messzwecken und werden z.B. in Elektrizitätszählern verwendet zur genauen Umwandlung eines Signals, das der elektrischen Leistung, d.h. einem Strom/Spannungs-Produkt, proportional ist, in eine proportionale Impulsfrequenz.

Der Aufbau und die Arbeitsweise einer Einrichtung der genannten Art ist aus der US-PS 41 24 821 bekannt. Dort wird das Prinzip der periodischen Polaritätsumschaltung zur Eliminierung einer Nullspannung ("Offset"-Spannung) verwendet, die in der Regel als nicht kompensierbarer zeit- oder temperaturabhängiger Anteil eines Eingangssignals sich direkt als Linearitätsfehler auf die Genauigkeit der Messung auswirkt. Dabei werden sowohl das zu wandelnde Signal als auch die Uebertragungsrichtung der Einrichtung periodisch und gleichzeitig umgepolt, so dass die beiden Vorzeichenänderungen des zu wandelnden Signals sich gegenseitig aufheben. Der Einfluss der Nullspannung dagegen, die nur einer Vorzeichenänderung der Uebertragung unterliegt, wird abwechselnd während je einer Halbperiode eines Umschaltsignals zum Signal addiert oder vom Signal subtrahiert, so dass die Integration der Nullspannung über eine ganzzahlige Anzahl Perioden des Umschaltsignals den Wert Null ergibt, unter der Bedingung, dass beide Halbperioden des Umschaltsignals genau gleich lang andauern. Da im Augenblick der Polaritätsumschaltung in einem Integrationskondensator in der Regel noch eine von Null unterschiedliche Restladung vorhanden ist, wird diese nach der Polaritätsumschaltung mit falscher Polarität wirksam und führt zu einer Verfälschung des Messresultates. Ueber eine längere Messzeit betrachtet, braucht diese Verfälschung keinen negativen Einfluss auf den Mittelwert der Impulsfrequenz zu haben, sie führt aber in jedem Fall zu momentanen Schwankungen, d.h. zu einer Modulation, der Impulsfrequenz. Um dies zu vermeiden, wird im Stand der Technik der Augenblick der Polaritätsumschaltung mit dem Ausgangssignal eines Komparators synchronisiert, der die Kondensatorspannung überwacht, so dass die Polaritätsumschaltung immer im Nulldurchgang der Kondensatorspannung erfolgt, d.h. im Augenblick, wenn die Kondensator-Restladung Null ist. Diese Lösung führt jedoch dazu, dass die beiden Halbperioden des Umschaltsignals nicht immer genau gleich, sondern nur mehr im statistischen Mittel gleich lang andauern und so wieder zu einer unregelmässigen Modulation der Ausgangsfrequenz der Einrichtung führen, was deren Eichung erschwert und erst nach einer untragbar langen Zeit ermöglicht.

Der Erfindung liegt die Aufgabe zugrunde, das Verfahren und die Einrichtung, die im Stand der Technik beschrieben sind, dermassen zu verbessern, dass sowohl die Modulation der Ausgangsfrequenz der Einrichtung durch ungleich lange Halbperioden des Umschaltsignals, als auch ihre Modulation durch Kondensator-Restladungen, die im Augenblick der Polaritätsumschaltung noch vorhanden sind, vermieden werden und dass somit eine schnelle und präzise Eichung der Einrichtung ohne lange Wartezeiten möglich ist.

Die genannte Aufgabe wird erfindungsgemäss durch die im Kennzeichen des Anspruchs 1 bzw. des Anspruchs 7 angegebenen Merkmale gelöst.

In der älteren EP 0 221 402 A1 ist schon ein Analog-Frequenz-Wandler beansprucht, dessen Integrator aus einem Kondensator besteht, der im Rückkopplungszweig eines Operationsverstärkers angeordnet ist und dessen Komparator eine umpolbare Vergleichsspannung aufweist. Dabei wird ein Konstantstrom, der den Kondensator entweder auflädt oder entlädt, durch Umschalten zwischen zwei Konstantstromquellen erzielt, während ein entsprechender Strom bei der vorliegenden Erfindung von einer dauernd angeschalteten Stromquelle und einer abschaltbaren Stromquelle, die den doppelten Strom liefert, erreicht wird, wobei beide Stromquellen an unterschiedlichen Stellen an der Schaltung angeschlossen sind. Zusätzlich wird bei der Erfindung von der Frequenz der erzeugten rechteckförmigen Ausgangsimpulse noch eine konstante Referenzfrequenz subtrahiert.

Ausführungsbeispiele der Erfindung sind in der Zeichnung dargestellt und werden im folgenden näher beschrieben.

Es zeigen:

Fig. 1 ein Blockschaltbild einer ersten Variante der Einrichtung,

Fig. 2 ein Blockschaltbild einer zweiten Variante der Einrichtung,

Fig. 3 ein Blockschaltbild einer dritten Variante der Einrichtung,

Fig. 4 zur ersten Variante gehörige Zeitdiagramme,

Fig. 5 ein Blockschaltbild eines Ausgangsfrequenzteilers,

Fig. 6 ein Blockschaltbild eines Elektrizitätszählers,

Fig. 7 ein Schaltbild des Eingangsteils einer Schaltung und

Fig. 8 ein Blockschaltbild einer vierten Variante der Einrichtung.

Gleiche Bezugszahlen bezeichnen in allen Figuren der Zeichnung gleich Teile.

Alle Komponenten der beschriebenen Einrichtungen sind z.B. in CMOS-Technologie aufgebaut und werden dann von einer positiven Speisegleichspannung $V_{DD}$ und einer negativen Speisegleichspannung $-|V_{SS}|$ gespeist, die beide die Masse als Bezugspotential besitzen. Die Speisegleichspannungen $V_{DD}$ und $-|V_{SS}|$ werden z.B. mit Hilfe eines Netzgleichrichters auf an sich bekannte Weise von einer Netzwechselspannung $u_N$ abgeleitet. In der Zeichnung sind der Netzgleichrichter und die Speisegleichspannungen $V_{DD}$ und $-|V_{SS}|$, obwohl immer vorhanden, aus Grunden der besseren Uebersichtlichkeit nicht dargestellt.

In der Zeichnung sind alle fakultativ vorhandenen Verbindungen und Komponenten gestrichelt gezeichnet. Alle Takteingänge, die mit positivge-henden Flanken gesteurt werden, sind in der Zeichnung symbolisch mit je einem weissen Dreieck gekennzeichnet, während alle Takteingänge, die mit negativgehenden Flanken gesteuert werden, symbolisch mit je einem schwarzen Dreieck versehen sind.

Das zu wandelnde Signal $u_H$ ist entweder ein Messsignal, z.B. eine elektrische Spannung, oder ein von Messsignalen abgeleitetes Signal, wie z.B. eine elektrische Leistung, die bekanntlich dem Produkt aus einem Strom und einer Spannung entspricht.

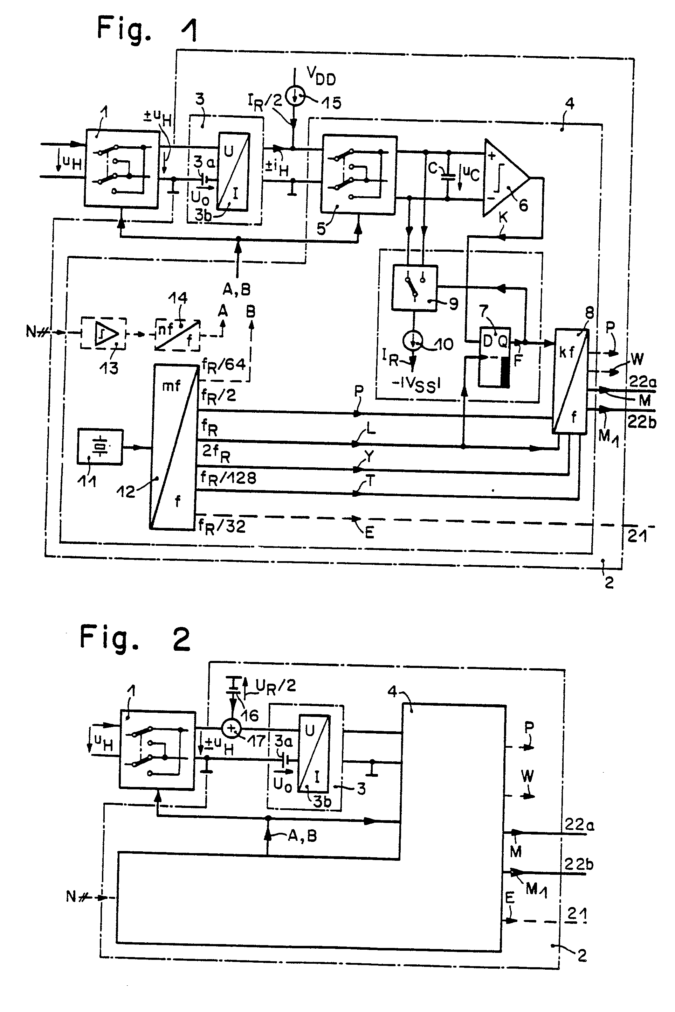

Die in den Figuren 1 bis 3 dargestellten drei Varianten der Einrichtung sind ähnlich aufgebaut und unterscheiden sich nur in ihrem Eingangsteil. Die drei Varianten bestehen jeweils aus einer Kaskadenschaltung eines ersten Polumschalters 1 und einer nachgeschalteten Schaltung 2. Die Schaltung 2 enthält in allen Fällen eine Kaskadenschaltung eines Spannungs/Strom-Wandlers 3 und einer nachgeschalteten Schaltung 4, wobei der Eingang des Spannungs/Strom-Wandlers 3 einen Signaleingang der Schaltung 2 bildet. Die Schaltung 4 besteht in allen Fällen (siehe Fig. 1) aus einem zweiten Polumschalter 5, einem Kondensator C, einem Komparator 6, einem D-Flip Flop 7, einem Ausgangsfrequenzteiler 8, einem Umschalter 9, einer Konstantstromquelle 10, einem Taktgenerator 11, einem Taktfrequenzteiler 12, einem fakultativ vorhandenen Schmitt-Trigger 13 und einem fakultativ vorhandenen Umschaltfrequenzteiler 14.

In der ersten Variante (siehe Fig. 1) enthält die Schaltung 2 noch eine weitere Konstantstromquelle 15 als Signalquelle, deren erster Pol mit einem nicht an Masse liegenden Ausgangspol des Spannungs/Strom-Wandlers 3 verbunden ist, während ihr zweiter Pol an der positiven Speise-gleichspannung $V_{DD}$ liegt.

In der zweiten Variante (siehe Fig. 2) enthält die Schaltung 2 noch eine Konstantspannungsquelle 16 als Signalquelle, deren erster Pol mit einem ersten Eingang eines Addiergliedes 17 verbunden ist, während ihr zweiter Pol an Masse liegt. Ein zweiter Eingang des Addiergliedes 17 stellt einen nicht an Masse liegenden Eingangspol der Schaltung 2 dar, während der Ausgang des Addiergliedes 17 auf einen nicht an Masse liegenden Eingangspol des Spannungs/Strom-Wandlers 3 geführt ist.

In der dritten Variante (siehe Fig. 3) ist zwischen dem ersen Polumschalter 1 und der Schaltung 2 zusätzlich ein Hochpassverstärker 18 in Kaskade geschaltet, der z.B. aus einem Verstärker 19 und einem in Kaskade nachgeschalteten Hochpassfilter 20 besteht.

In den drei Varianten sind die Ein- und Ausgänge der Polumschalter 1 und 5 sowie des Spannungs/Strom-Wandlers 3 alle zweipolig, wobei je ein Eingangspol des Spannungs/Strom-Wandlers 3 und des Polumschalters 5 an Masse liegt. Der zweipolige Eingang des Polumschalters 5 bildet einen zweipoligen Eingang der Schaltung 4.

Sein zweipoliger Ausgang ist auf den Kondensator C geführt, dessen erster Pol zusätzlich noch mit einem nichtinvertierenden Eingang des Komparators 6 und über einen Arbeitskontakt des Umschalters 9 mit einem ersten Pol der Konstantstromquelle 10 verbunden ist, während sein zweiter Pol zusätzlich noch auf einen invertierenden Eingang des Komparators 6 und über einen Ruhekontakt des Umschalters 9 auf den ersten Pol der Konstantstromquelle 10 geführt ist, deren zweiter Pol an der negativen Speisegleichspannung $-|V_{SS}|$ liegt. Der Ausgang des Komparators 6 ist mit einem D-Eingang des D-Flip Flops 7 verbunden, dessen Q-Ausgang einerseits auf einen Steuereingang des Umschalters 9 und anderseits auf einen ersten Signaleingang des Ausgangsfrequenzteilers 8 geführt ist.

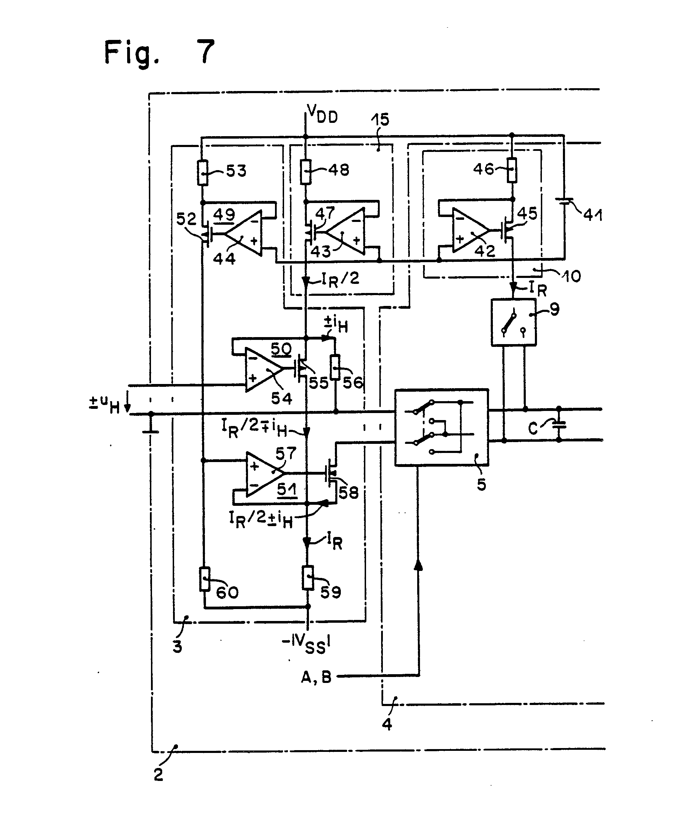

Der Ausgang des Taktgenerators 11 ist mit einem Eingang des Taktfrequenzteilers 12 verbunden, der z.b. sechs Ausgänge besitzt. Sein erster Ausgang, an dem ein Taktsignal P der Frequenz $f_R/2$ ansteht, ist auf einen zweiten Signaleingang des Ausgangsfrequenzteilers 8 geführt, sein zweiter Ausgang, an dem ein Taktsignal L der Frequenz $f_R$ ansteht, ist mit einem Takteingang des D-Flip Flops 7 und mit einem ersten Takteingang des Ausgangsfrequenzteilers 8 verbunden, während sein dritter Ausgang, an dem ein Taktsignal T der Frequenz $f_R/128$ ansteht, auf einen zweiten Takteingang des Ausgangsfrequenzteilers 8 geführt ist. Sein vierter Ausgang, an dem ein Taktsignal Y der Frequenz $2f_R$ ansteht, ist mit einem dritten Takteingang des Ausgangsfrequenzteilers 8 verbunden. Der fünfte Ausgang des Taktfrequenzteilers 12, an dem ein Taktsignal E der Frequenz $f_R/32$ ansteht, ist fakultativ vorhanden und wird z.B. in den in der Fig. 6 dargestellten Elektrizitätszähler verwender. Er ist mit einem fakultativ vorhandenen Taktausgang 21 der Schaltung 2 verbunden.

Eine Wechselsteuerspannung N, z.B. eine 50 Hz- oder 60 Hz-Netzwechselspannung, speist fakultativ zweipolig den Eingang des Schmitt-Triggers 13, dessen Ausgang mit dem Eingang des Umschaltfrequenzteilers 14 verbunden ist. Die miteinander verbundenen Steuereingänge der beiden Polumschalter 1 und 5 werden entweder vom Ausgang des Umschaltfrequenzteilers 14 mit einem Umschaltsignal A oder vom sechsten Ausgang des Taktfrequenzteilers 12 mit einem Umschaltsignal B über eine Drahtverbindung gespeist. Falls das Umschaltsignal B verwendet wird, können natürlich der Schmitt-Trigger 13 und der Umschaltfrequenzteiler 14 eingespart werden. Zwei der vier Ausgänge des Ausgangsfrequenzteilers 8 sind gleichzeitig die beiden Signalausgänge 22a und 22b der Schaltung 2. An einem dieser beiden Signalausgänge, nämlich am Ausgang 22a, steht ein Signal M an, welches einem positiven Wert des Signals $u_H$ entspricht, während am anderen Signalausgang 22b ein

Signal $M_1$ ansteht, welches einem negativen Wert des Signals $u_H$ entspricht.

Die beiden Polumschalter 1 und 5 sind gleich aufgebaut und bestehen je aus einem zweipoligen Umschalter, der z.B. mit Hilfe bekannter Halbleiter-Analogschalter in CMOS-Technologie aufgebaut ist. Dabei ist (siehe Fig. 1, Symbole in der Blöcken 1 und 5) ein erster Eingangspol der Polumschalter 1 und 5 sowohl über einen ersten ihrer Ruhekontakte mit einem ersten ihrer Ausgangspole als auch über einen ersten ihrer Arbeitskontakte mit einem zweiten ihrer Ausgangspole verbunden, während ihr zweiter Eingangspol sowohl über einen zweiten ihrer Ruhekontakte mit dem zweiten ihrer Ausgangspole als auch über einen zweiten ihrer Arbeitskontakte mit dem ersten ihrer Ausgangspole verbunden ist. Der Umschalter 9 ist einpolig und z.B. auch mit Hilfe bekannter Halbleiter-Analogschalter in CMOS-Technologie aufgebaut.

Der Taktfrequenzteiler 12 und der Umschaltfrequenzteiler 14 sind z.B. mit Hilfe bekannter Binärzähler in CMOS-Technologie aufgebaut und ermöglichen eine synchrone Frequenzteilung durch eine Zahl $2^x$, wobei x ganzzahlig ist.

Der Taktgenerator 11 ist z.B. quarzstabilisiert und erzeugt rechteckförmige Taktimpulse z.B. der Frequenz $2^{15}$ Hz = 32,768 kHz. Diese Frequenz wird im nachgeschalteten Taktfrequenzteiler 12 z.B. durch m geteilt, wobei m die Wert $2^4, 2^5, 2^6$, $2^{10}, 2^{11}$ und $2^{12}$ besitzt, zur Erzeugung der Frequenzen $2f_R = 2^{11}$ Hz des Taktsignals Y, $f_R = 2^{10}$ Hz des Taktsignals L, $f_R/2 = 2^9$ Hz des Taktsignals P, $f_R/32 = 2^5$ Hz des Taktsignals E, $f_R/64 = 2^4$ Hz = 16 Hz des Umschaltsignals B und $f_R/128 = 2^3$ Hz des Taktsignals T.

Die Weckselsteuerspannung N wird im Schmitt-Trigger 13 in ein periodisches rechteckförmiges Impulssignal der gleichen Frequenz umgewandelt. Die beiden Schaltschwellen des Schmitt-Triggers 13 sind vorzugsweise so gewählt, dass die Umschaltung im nachgeschalteten Umschaltfrequenzteiler 14 genau bei den Nulldurchgängen der Wechselsteuerspannung N erfolgt. Im nachfolgenden Umschaltfrequenzteiler 14 wird dann die z.B. 50 Hz- bzw. 60 Hz-Frequenz dieses rechteckförmigen Impulssignals durch n geteilt, wobei n z.B. den Wert $2^2$ besitzt, zur Erzeugung einer Frequenz von 12,5 Hz bzw. 15 Hz des Umschaltsignals A. Die beiden Polumschalter 1 und 5 werden somit synchron und periodisch mit der Frequenz 12,5 Hz oder 15 Hz (Umschaltsignal A) bzw. mit der Frequenz 16 Hz (Umschaltsignal B) vom gleichen Umschaltsignal A bzw. B gesteuert und umgeschaltet. Der Schmitt-Trigger 13 und der Umschaltfrequenzteiler 14 bzw. der Taktgenerator 11 und teilweise der Taktfrequenzteiler 12 bilden somit zusammen eine Steuerschaltung zur Erzeugung des periodischen Umschaltsignals A bzw. B der beiden Polumschalter 1 und 5.

Der Spannungs/Strom-Wandler 3 besitzt in der Praxis eine unvermeidbare Nullspannung ("Offset"-Spannung) $U_o$, die in den Figuren 1 und 2 symbolisch dargestellt wurde durch eine Spannungsquelle 3a, die in Reihe geschaltet ist mit einem Eingangspol eines idealen, nullspannungslosen Spannungs/Strom-Wandlers 3b. Die Spannungsquelle 3a und der ideale Spannungs/Strom-Wandler 3b bilden zusammen den nichtidealen Spannungs/Strom-Wandler 3.

Das D-Flip Flop 7 wird z.B. mit negativgehenden Flanken gesteuert.

In allen drei Varianten wird ein zu wandelndes Signal $u_H$ in Gestalt einer elektrischen Spannung zweipolig dem Eingang des Polumschalters 1 zugeführt, der vom Umschaltsignal A oder B gesteuert ist. Der Polumschalter 1 polt das Signal $u_H$ periodisch um.

Während z.B. allen ungeradzahligen Halbperioden des Umschaltsignals A bzw. B erscheint das Signal $+u_H$ am Ausgang des Polumschalters 1 und während allen geradzahligen Halbperioden das Signal $-u_H$.

In der ersten Variante (siehe Fig. 1) wird das periodisch umgepolte Signal $\pm u_H$ im nachgeschalteten Spannungs/Strom-Wandler 3 in einen proportionalen Signalstrom $\pm i_H$ umgewandelt. Nach dieser Spannungs/Strom-Wandlung und noch vor einer nachfolgenden Integration wird am Ausgang des Spannungs/Strom-Wandlers 3 ein Gleichstrom $I_R/2$ als konstantes Referenzsignal zum durch den Spannungs/Strom-Wandler 3 erzeugten Stromsignal $\pm i_H$ addiert zwecks Bildung eines Summensignals $\pm i_H + I_R/2$. Die Konstantstromquelle 15 erzeugt dabei den Gleichstrom $I_R/2$.

In der zweiten Variante (siehe Fig. 2) wird dagenen zuerst zum periodisch umgepolten Signal $\pm u_H$ am Eingang des Spannungs/Strom-Wandlers 3 eine Gleichspannung $U_R/2$ als konstantes Referenzsignal mit Hilfe des Addiergliedes 17 addiert. Ein so erhaltenes Summensignal $\pm u_H + U_R/2$ wird im nachfolgenden Spannungs/Strom-Wandler 3 in ein proportionales Stromsignal $\pm i_H + I_R/2$ umgewandelt. Dabei entspricht das Stromsignal $\pm i_H$ wieder dem Signal $\pm u_H$ und der Gleichstrom $I_R/2$ der Gleichspannung $U_R/2$. Die Gleichspannung $U_R/2$ wird von der Konstantspannungsquelle 16 erzeugt.

In der ersten und der zweiten Variante ist somit der Eingangsstrom des Polumschalters 5 ein dem so erhaltenen Summensignal $\pm u_H + U_R/2$ bzw. $\pm i_H + I_R/2$ proportionales Signal $\pm i_H + I_R/2$. Der Polumschalter 5, der zwischen dem Spannungs/Strom-Wandler 3 und dem Kondensator C angeordnet ist, polt nachfolgend dieses Signal synchron zur periodischen Umpolung des Signals $u_H$ ebenfalls periodisch um, so dass der Kondensator C vom Polumschalter 5 her dauernd einen Strom $i_H \pm I_R/2$ geliefert bekommt. Das zweimal periodisch umgepolte, zu $u_H$ proportionale Signal $i_H$ wird schliesslich im Kondensator C integriert.

Da der Spannungs/Strom-Wandler 3, wie bereits erwähnt, an seinem Eingang in der Regel eine Nullspannung $U_o$ besitzt, der am Ausgang des Spannungs/Strom-Wandlers 3 ein proportionaler Strom $I_o$ entspricht, ist der Eingangsstrom des Polumschalters 5 in Wirklichkeit nicht ideal gleich $\pm i_H + I_R/2$, sondern in beiden Varianten gleich $\pm i_H + I_R/2 + I_o$.

Der Wert des Referenzsignals $U_R/2$ bzw. $I_R/2$ entspricht dem halben Wert des von der Konstantstromquelle 10 gelieferten Referenzstromes $I_R$ und muss gleichzeitig die Bedingung $U_R/2 > |\pm u_H + U_o|$ bzw. $I_R/2 > |\pm i_H + I_o|$ erfüllen. Anders ausgedrückt: Der Wert des konstanten Referenzsignals $U_R/2$ bzw. $I_R/2$ ist grösser zu wählen als der um den Einfluss $U_o$ bzw. $I_o$ der Nullspannung $U_o$ erhöhte, am Ort der Addition vorhandene Wert der Amplitude $u_H$ bzw. $i_H$ des periodisch umgepolten Signals $\pm u_H$ bzw. $\pm i_H$.

Der Wert der Nullspannung $U_o$ im Vergleich zum Wert des Signals $u_H$ bzw. der Wert des Stromes $I_o$ im Vergleich zum Wert des Stromes $i_H$ ist in der Regel sehr klein, so dass nur ein sehr kleiner Teil des Aussteuerungsbereichs der Einrichtung vom Strom $I_o$ belegt wird. In kritischen Anwendungen, wo der maximale Wert des Signals $u_H$ im Vergleich zur Nullspannung $U_o$ sehr klein ist, kann der für das Signal $u_H$ verbleibende Aussteuerungsbereich im Verhältnis zum maximal möglichen Aussteuerungsbereich $U_R/2$ bzw. $I_R/2$ unzulässig klein werden. Daher ist es vorteilhaft, zur Verbesserung der Dynamik gemäss der dritten Variante (siehe Fig. 3) das periodisch umgepolte Signal $\pm u_H$ im Hochpassverstärker 18 wechselspannungsmässig zu verstärken, bevor es der Schaltung 2 zur weiteren Verarbeitung zugeleitet wird, wodurch das Verhältnis des Signalstromes $i_H$ zum Strom $i_o$ bzw. des Signals $u_H$ zur Nullspannung $U_o$ verbessert wird. Der Hochpassverstärker 18 hat keine oder nur eine sehr niedrige Gleichspannungsverstärkung, was z.B. durch das Vorhandensein des Hochpassfilters 20 im Hochpassverstärker 18 verwirklicht wird. Die Zeitkonstante des Hochpassverstärkers 18 muss genügend klein gewählt werden, damit das verstärkte, rechteckförmige Signal $\pm u_H$ mit ausreichend kleiner Verzerrung übertragen wird. In der dritten Variante hat die Schaltung 2 entweder den in der Fig. 1 oder den in der Fig. 2 dargestellten Aufbau.

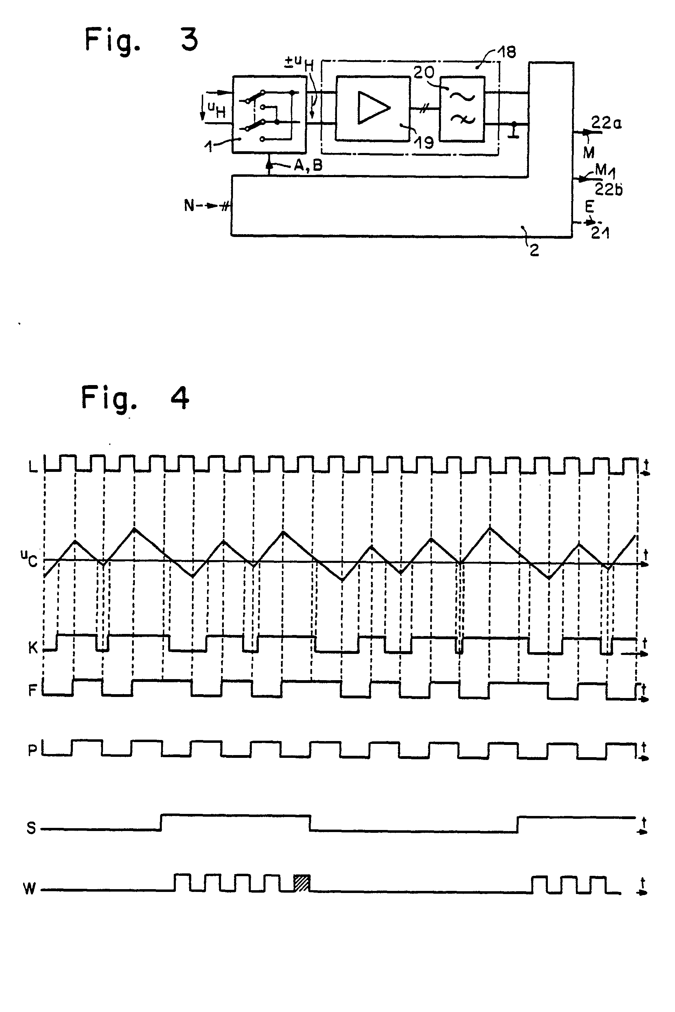

Der Spannungs/Strom-Wandler 3 und der nachgeschaltete Kondensator C bilden zusammen in allen drei Varianten einen Integrator 3;C, wobei die Signalquelle 15 bzw. 16 jeweils in dessen Eingangsteil angeordnet ist. Der dem Integrator 3;C nachgeschaltete Komparator 6 überwacht dessen Ausgangsspannung, nämlich die Kondensatorspannung $u_c$, zwecks Steuerung des Zu- und Abschaltens des von der Konstantstromquelle 10 gelieferten, konstanten Referenzstromes $I_R$ bei Ueber- bzw. Unterschreitung eines Schwellwertes unter gleichzeitiger Erzeugung rechteckförmiger Ausgangsimpulse. Der zeitliche Verlauf der Kondensatorspannung $u_C$ ist für den Fall, dass das Signal $u_H$ konstant und positiv ist und dass die Nullspannung $U_o$ null ist, in der zweiten Zeile der Fig. 4 dargestellt. In diesem Fall hat die Kondensatorspannung $u_C$ einen sägezahnförmigen Verlauf, dessen Flanken alle konstante Neigungen besitzen und dessen positiv- und negativgehenden Flanken alle jeweils unter sich parallel verlaufen.

Der vom D-Flip Flop 7 gesteuerte Umschalter 9 dient dem Zu- und Abschalten des Referenzstromes $I_R$. Wie bereits erwähnt, wird dem Kondensator C vom Polumschalter 5 her ein Strom $i_H \pm I_R/2 \pm I_o$ geliefert, wobei sich das Pluszeichen auf ungeradzahlige und das Minuszeichen auf geradzahlige Halbperioden des Umschaltsignals A bzw. B bezieht. Wenn zu Beginn das Ausgangssignal F des D-Flip Flops 7 einen Logikwert "0" besitzt, dann nimmt zu Anfang der Umschalter 9 die in der Fig. 1 dargestellte Position ein. Dann ist die Konstantstromquelle 10 während der ungeraden Halbperioden des Umschaltsignals A bzw. B, während der der Polumschalter 5 ebenfalls die in der Fig. 1 dargestellte Position einnimmt, immer nur mit dessen momentan an Masse liegendem Anschluss verbunden. Der Referenzstrom $I_R$ der Konstantstromquelle 10 fliesst in die Masse und kann den Kondensator C nicht laden. Während einer jeden ungeradzahligen Halbwelle des Umschaltsignals A bzw. B wird somit der Kondensator C nur vom Polumschalter 5 her mit dem Strom $i_H + I_R/2 + I_o$ geladen. Dadurch steigt die vom Komparator 6 überwachte Spannung $u_c$ am Kondensator C an. Der Komparator 6 besitzt z.B. einen Eingangsschwellwert von 0 Volt. Ueberschreitet die Spannung $u_c$ den Eingangsschwellwert des Komparators 6, dann ändert dessen Ausgangssignal K seinen Wert vom Logikwert "0" auf einen Logikwert "1". Der zeitliche Verlauf des Ausgangssignals K des Komparators 6 ist in der dritten Zeile der Fig. 4 dargestellt. Die Zustandsänderung des Ausgangssignals K wird mit der nächsten negativgehenden Flanke des hochfrequenten Taktsignals L in das den Komparator 6 nachgeschaltete D-Flip Flop 7 übernommen. Das D-Flip Flop 7 dient dazu, das rechteckförmige Ausgangssignal K des Komparators 6 mit dem rechteckförmigen Taktsignal L, dessen Frequenz, wie bereits erwähnt, z.B. $2^{10}$ Hz beträgt, zu synchronisieren. Der zeitliche Verlauf des Taktsignals L ist in der ersten Zeile und der zeitliche Verlauf des rechteckförmigen Ausgangssignals F des D-Flip Flop 7 in der vierten Zeile der Fig. 4 dargestellt. Die von D-Flip Flop 7 übernommene Wertänderung steuert mit Hilfe des Ausgangssignals F den Umschalter 9 und schaltet diesen um, der jetzt die entgegengesetzte von der in der Fig. 1 dargestellte Position einnimmt. Dadurch wird jetzt zustätzlich der Referenzstrom $I_R$ der Konstantstromquelle 10 durch den Kondensator C fliessen.

Der Ladestrom des Kondensators C ist damit gleich: $i_H + I_R/2 + I_o - I_R = i_H - I_R/2 + I_o$, d.h. der Term $I_R/2$ hat sein Vorzeichen geändert. Da jedoch, wie bereits erwähnt, die Bedingung $I_R/2 > |i_H + I_o|$ gilt, ist der resultierende Ladestrom negativ.

Die Spannung $u_C$ am Kondensator C sinkt und, wenn sie den Eingangsschwellwert des Komparatos 6 unterschreitet, nimmt dessen Ausgangssignal K wieder seinen ursprünglichen Logikwert "0" an. Auch diese Wertänderung wird wieder durch die nächste negativgehende Flanke des Taktsignals L in das D-Flip Flop 7 übernommen, was dazu führt, dass der Umschalter 9 wieder seine ursprüngliche Position einnimmt, so dass ein neuer Zyklus beginnen kann. Dies wiederholt sich so oft, bis dass die ungeradzahlige Halbperiode des Umschaltsignals A bzw. B beendet ist. Jedem Impuls des Ausgangssignals F entspricht dabei eine einzige, mit Hilfe des Referenzstromes $I_R$ durchgeführte Entladung des Kondensators C.

Am Ende einer jeden ungeradzahligen Halbperiode des Umschaltsignals A bzw. B werden die beiden Polumschalter 1 und 5 vom Umschaltsignal A bzw. B synchron umgeschaltet, so dass sie beide die entgegengesetzte von der in der Fig. 1 dargestellte Position einnehmen. Durch das Umschalten des Polumschalters 5 wird sowohl der Kondensator C als auch der Einfluss der Konstantstromquelle 10 umgepolt. Diesmal ist die Konstantstromquelle 10 bei der in der Fig. 1 dargestellten Position des Umschalters 9 mit den beiden Polen des Kondensators C verbunden und somit in Betrieb. Unter der Annahme, dass zu Beginn der nun beginnenden geradzahligen Halbperiode des Umschaltsignals A bzw. B der Umschalter 9 z.B. wieder die in der Fig. 1 dargestellte Position einnimmt, wird der Kondensator C sowohl vom Polumschalter 5 her mit dem Strom $i_H - I_R/2 - I_O$ als auch von der Konstantstromquelle 10 her mit dem Referenzstrom $I_R$ geladen.

Der totale Ladestrom ist somit:

$$i_H - I_R/2 - I_O + I_R = i_H + I_R/2 - I_O.$$

Die Kondensatorspannung $u_C$ steigt an und, wenn sie den Eingangsschwellwert des Komparators 6 überschreitet, ändert dessen Ausgangssignal K seinen Wert vom Logikwert "0" auf den Logikwert "1". Diese Wertänderung führt auf die bereits beschriebene Weise dazu, dass der Umschalter 9 umschaltet und dadurch die Konstantstromquelle 10 mit dem an Masse liegenden Anschluss des Kondensators C verbunden wird. Der Kondensator C wird jetzt nur mehr vom Polumschalter 5 her mit dem Strom $i_H - I_R/2 - I_O$ geladen, der negativ ist, da die Bedingung $i_R/2 > |\pm I_H + I_O|$ gilt. Die Kondensatorspannung $u_C$ nimmt ab und, wenn sie den Eingangsschwellwert des Komparators 6 unterschreitet, dann ändert dessen Ausgangssignal seinen Wert zurück auf den Logikwert "0", wodurch der Umschalter 9 in seine Ausgangsposition zurückgeschaltet wird, so dass ein neuer Zyklus beginnen kann. Dies wiederholt sich so oft, bis dass die geradzahlige Halbperiode des Umschaltsignals A bzw. B beendet ist.

Zusammengefasst gilt:

Während einer ungeradzahligen Halbperiode des Umschaltsignals A bzw. B wird der Kondensator C abwechslungsweise mit einem Strom $i_H + I_R/2 + I_O$ galaden und mit einem Strom $i_H - I_R/2 + I_O$ entladen. Während einer geradzahligen Halbperiode des Umschaltsignals A bzw. B wird der Kondensator C dagegen abwechslungsweise mit einem Strom $i_H + I_R/2 - I_O$ geladen und mit einem Strom $i_H - I_R/2 - I_O$ entladen. Beide Arten Halbperioden unterscheiden sich somit nur durch das Vorzeichen des Stromes $I_O$. Da die Umschaltsignale A und B durch die Art ihrer Erzeugung genau gleich lange Halbperioden besitzen und da das Vorzeichen des Stromes $I_O$ in zwei aufeinanderfolgenden Halbperioden unterschiedlich ist, eliminiert sich $I_O$ und damit auch der Einfluss der Nullspannung $U_O$ bei einer Integration über eine ganzzahlige Anzahl Perioden des Umschaltsignals A bzw. B oder bei einer Integration über eine genügend lange Zeit.

Die Ladung, die dem Kondensator C während einer jeden ungeradzahligen Halbperiode durch den Strom $i_H + I_R/2 + I_O$ vom Polumschalter 5 her dauernd zufliesst, wird ihm jeweils fortlaufend in kleinen, konstanten, genau definierten Ladungsmengen $Q_R = I_R/f_R$ durch das Zuschalten der Konstantstromquelle 10 entzogen unter gleichzeitiger Abgabe eines rechteckförmigen Impulses pro Quantum am Q-Ausgang des D-Flip Flops 7. Die Ladung, die dem Kondensator C während einer jeden geradzahligen Halbperiode durch den Strom $i_H - I_R/2 - I_O$ vom Polumschalter 5 her dauernd entzogen wird, wird ihm jeweils fortlaufend in kleinen, konstanten, genau definier-ten Ladungsmengen $Q_R$ durch das Zuschalten der Konstantstromquelle 10 wieder zugeführt, so dass der totale Ladestrom des Kondensators C dem Summenstrom

$$(i_H - I_R/2 - I_O) + I_R = i_H + I_R/2 - I_O$$

entspricht, wobei auch diesmal wieder gleichzeitig ein rechteckförmiger Impuls pro Quantum am Q-Ausgang des D-Flip Flops 7 abgegeben wird. Jeder dieser Impulse ist somit ein Mass für das kleine, genau definierte Ladungsquantum, das dem Kondensator C mit Hilfe des Referenzstromes $I_R$ entzogen bzw. zugeführt wird. Bedingt durch die Umpolung des Kondensators C ist die Polarität des Ladestromes $i_H + I_R/2 \pm I_O$ unverändert und somit wird die zur Zeit der periodischen Umpolung im Kondensator C noch anstehende Restladung in der nachfolgenden Halbperiode mit der richtigen Polarität berücksichtigt, so dass keine durch die Restladung bedingte Modulation der Ausgangsfequenz entstehen kann.

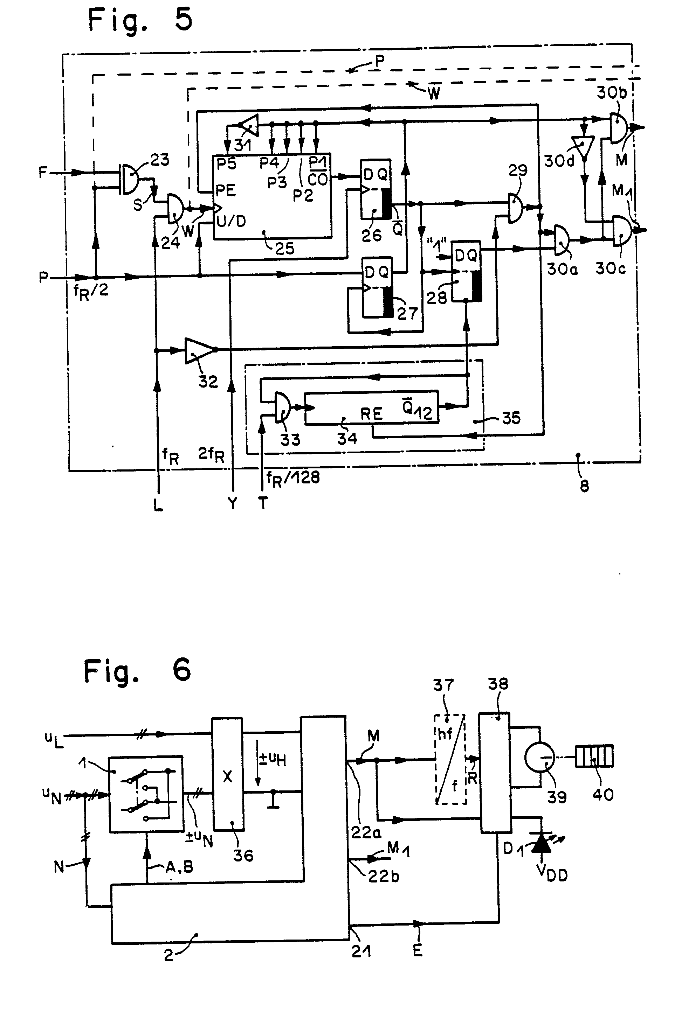

Das mit Hilfe der Integration und des Komparators 6 erzeugte Ausgangssignal F des D-Flip Flops 7 besteht aus rechteckförmigen Impulsen. Die mittlere Frequenz $f_F$ dieser Impulse ist proportional dem Summenstrom $i_H + I_R/2$ und damit um eine konstante Frequenz $f_R/2$ zu gross, wenn die Frequenz $f_R/2$ die Frequenz darstellt, die dem Wert des Referenzsignals $U_R/2$ bzw. $I_R/2$ entspricht. Die Frequenz $f_R/2$ ist auch die Frequenz der rechteckförmigen Impulse des Taktsignals P. Um eine Ausgangsfrequenz der Einrichtung zu erhalten, die nur proportional dem Signalstrom $i_H$ und damit auch nur proportional dem Signal $u_H$ ist, muss somit noch von der Frequenz $f_F$ des Ausgangssignals F die konstante Referenzfrequenz $f_R/2$ des Taktsignals P subtrahiert werden. Dies geschieht mit Hilfe eines in der Gestalt des Ausgangsfrequenzteilers 8 am Ausgang der Einrichtung vorhandenen Vorwärts/Rückwärts-Zählers, indem dort die Impulse des Ausgangssignals F des D-Flip Flops 7 vorwärts und diejenigen des Taktsignals P rückwärts gezählt werden. Gleichzeitig teilt der Ausgangsfrequenzteiler 8 noch die Frequenzdifferenz $f_F - f_R/2$ durch eine Zahl k. Der Aufbau des Ausgangsfrequenzteilers 8 ist aus der Fig. 5 ersichtlich.

Der in der Fig. 5 dargestellte Ausgangsfrequenzteiler 8 besteht aus einem Exklusiv-Oder-Gatter 23, einem ersten Und-Gatter 24, einem ersten Zähler 25, einem ersten Flip Flop 26, einem zweiten Flip FLop 27, einem dritten Flip Flop 28, einem zweiten Und-Gattere 29, einem dritten Und-Gatter 30a, einem vierten Und-Gatter 30b, einem fünften Und-Gatter 30c, einem ersten Inverter 30d, einem zweiten Inverter 31, einem dritten Inverter 32, einem sechsten Und-Gatter 33 und einem zweiten Zähler 34. Der erste Zähler 25 ist ein binärer Vorwärts-Rückwärts-Zähler, der z.B. vorwärts zählt, wenn an seinem U/D-Eingang ein Logikwert "1" ansteht, und der rückwärts zählt, wenn an seinem U/D-Eingang ein Logikwert "0" ansteht. Alle Flip Flop 26 bis 28 sind z.B. D-Flip Flop. Das Und-Gatter 33 und der Zähler 34 bilden zusammen einen monostabilen Multivibrator 35. Die Takteingänge des Zählers 25, des Flip Flops 26 und des Flip Flops 27 werden z.B. mit positivgehenden Flanken und die Takteingänge des Flip Flops 28 und des Zähles 34 z.B. mit negativgehenden Flanken gesteuert. Das Flip Flop 28, das Und-Gatter 30a und der monostabile Multivibrator 35 bilden eine Leerlauf-Verhinderungsschaltung 28; 30a; 35, die insbesondere bei Verwendung der Einrichtung in einem Elektrizitätszähler von Bedeutung ist.

Der erste Signaleingang des Ausgangsfrequenzteilers 8 ist mit einem ersten Eingang des Exklusiv-Oder-Gatters 23 verbunden und wird vom Ausgangssignal F des D-Flip Flops 7 angesteuert. Sein zweiter Signaleingang ist auf einen zweiten Eingang des Exklusiv-Oder-Gatters 23, auf den U/D-Eingang des Zählers 25 und auf einen D-Eingang des Flip Flops 27 geführt. Er wird vom Taktsignal P mit einer Frequenz $f_R/2$ angesteuert. Der erste Takteingang des Ausgangsfrequenzteilers 8 ist mit einem ersten Eingang des Und-Gatters 24 und über den Inverter 32 mit einem ersten Eingang des Und-Gatters 29 verbunden. Er wird vom Taktsignal L mit der Frequenz $f_R$ gespeist. Sein zweiter Takteingang ist auf einen ersten Eingang des Und-Gatters 33 geführt und wird vom Taktsignal T mit der Frequenz $f_R/128$ gespeist. Sein dritter Takteingang ist mit dem Takteingang des Flip Flops 26 verbunden und wird vom Taktsignal Y mit der Frequenz $2f_R$ gespeist.

Es sind miteinander verbunden:

— Der Ausgang des Exklusiv-Oder-Gatters 23 mit einem zweiten Eingang des Und-Gatters 24, dessen Ausgang auf einen Takteingang des Zählers 25 geführt ist,

— der "Carry Out"-Ausgang $\overline{CO}$ des Zählers 25 mit einem D-Eingang des Flip Flops 26, dessen $\overline{Q}$-Ausgang auf einen zweiten Eingang des Und-Gatter 29, auf einen Takteingang des Flip Flops 27 und auf einen Takteingang des Flip Flops 28 geführt ist,

— der Ausgang des Und-Gatters 29 mit einem ersten Eingang des Und-Gatters 30a, mit dem Ladeeingang PE des Zählers 25 und mit dem Rückstelleingang RE des Zählers 34,

— der Q-Ausgang des Flip Flops 27 mit den Paralleleingängen P1 bis P4 des Zählers 25 und dem ersten Eingang des Und-Gatters 30b sowie über den Inverter 31 mit dem Paralleleingang P5 des Zählers 25 und über den Inverter 30d mit dem ersten Eingang des Flip Flops 28 mit einem zweiten Eingang des Und-Gatters 30a, dessen Ausgang auf je einen zweiten Eingang der Und-Gatter 30b und 30c geführt ist, und

— der Ausgang des Und-Gatters 33 mit einem Takteingang des Zählers 34, dessen $\overline{Q}_{12}$-Ausgang auf einen zweiten Eingang des Und-Gatters 33 und auf einen invertierenden Rückstelleingang des Flip Flops 28 geführt ist.

Am D-Eingang des Flip Flops 28 liegt ein Logikwert "1". Die Ausgänge der Und-Gatter 30b und 30c bilden die beiden Ausgänge des Ausgangsfrequenzteilers 8, an dem die Signale M und $M_1$ anstehen.

Da der Zähler 25 nicht gleichzeitig vor- und rückwärts zählen kann, müssen alle Impulse des Ausgangssignals F und des Taktsignals P, die gleichzeitig an den beiden Signaleingängen des Ausgangsfrequenzteilers 8 erscheinen, mit Hilfe des Exklusiv-Oder-Gatters 23 eliminert werden. Dies hat keinen negativen Einfluss auf den Zählwert des Zählers 25, da ein vorwärts- und ein rückwärtsgezählter Impuls sowieso einen Zählwert Null ergeben würden.

Am Ausgang des Exklusiv-Oder-Gatters 23 erscheint nur ein Logikwert "1", wenn die beiden Signale F und P unterschiedlich sind. Das Und-Gatter 24 dient als Impulsformer, der die Impulsdauer der Ausgangsimpulse des Exklusiv-Oder-Gatters 23 auf diejenige des Taktsignals L reduziert. In der Fig. 4 sind der zeitliche Verlauf des Taktsignals P in der fünften Zeile, derjenige des Ausgangssignals S des Exklusiv-Oder-Gatters 23 in der sechsten Zeile und derjenige des Ausgangssignals W des Und-Gatters 24 in der siebten Zeile dargestellt. Das Taktsignal P und das Ausgangssignal W sind auf je einen weiteren Ausgang des Ausgangsfrequenzteilers 8 geführt. Der Zähler 25 zählt die Ausgangsimpulse des Und-Gatters 24 vorwärts, wenn das Taktsignal P, das an seinem U/D-Eingang ansteht, einen Logikwert "1" besitzt, und rückwärts, wenn das Taktsignal P einen Logikwert "0" aufweist. Die negativgehenden Impulse am Ausgang $\overline{CO}$ des Zählers 25 werden mit der nächsten positivgehenden Flanke des Taktsignals Y in das Flip Flop 26 übernommen und erscheinen somit in der Regel leicht verzögert als positive Impulse am $\overline{Q}$-Ausgang des Flip Flops 26. Ihre Impulsdauer wird im nachfolgenden Und-Gatter 29 mit Hilfe des invertierten Taktsignals L auf die Dauer von dessen Impulsen beschränkt, d.h. das Und-Gatter 29 arbeitet ebenfalls als Impulsformer. Da wegen Rauschen oder der zeitweise wechselnden Polarität des Signals $u_H$, die Zählrichtung vorübergehend ändern kann, wird der Anfangszählwert des Zählers 25 nicht wie üblich gleich 0 = 00000 beim Vorwärtszählen bzw. in unserem Beispiel gleich dem Maximalwert 31 = 11111 beim Rückwärtszählen gewählt, sondern annähernd in der Mitte des Zählbereichs gelegt, nämlich z.B. bei einem Wert 16 = 10000, wenn vorher Zustand 00000 beim Rückwärtszählen erreicht wurde (P = "0"), oder bei einem Wert 15 = 01111, wenn vorher Zustand 11111 beim Vorwärtszählen erreicht wurde (P = "1"). Dies geschieht, indem mit jeder positivgehenden Flanke der Ausgangsimpulse des Flip Flops 26 der gerade anstehende Logikwert des Taktsignals P in das Flip Flop 27 übernommen wird, wodurch dessen Q-Ausgang, zur Vorbereitung eines Parallel-Ladevorganges des Zählers 25, bei P = "0" eine Binärzahl 10000 = 16 oder bei P = "1" eine Binärzahl 01111 = 15 an die Paralleleingänge P5, P4, P3, P2, P1 des Zählers 25 anlegt. Jeder Ausgangsimpuls des Und-Gatters 29 lädt mit Hilfe des Ladeeingangs PE diesen Anfangswert in den Zähler 25 und stellt gleichzeitig mit Hilfe des Rückstelleingangs RE den Zähler 34 auf Null zurück. Der Ladevorgang des Zählers 25 lässt erneut einen Logikwert "1" an dessen Ausgang $\overline{CO}$ erscheinen, der, wieder in der Regel leicht verzögert, in das Flip Flop 26 übernommen wird und dadurch den positiven Impuls an dessen $\overline{Q}$-Ausgang beendet. Dadurch endet auch der Ausgangsimpuls des Und-Gatters 29. Falls das Flip Flop 28 noch nicht mit einem Logikwert "1" geladen war, geschieht dies jetzt durch die negativgehende Flanke des Ausgangsimpulses am $\overline{Q}$-Ausgang des Flip Flops 26, wodurch der Q-Ausgang des Flip Flops 28 nun das Und-Gatter 30a freigibt. Da aber gleichzeitig, wie bereits erwähnt, der Ausgangsimpuls des Und-Gatters 29 endet, erreicht dieser Ausgangsimpuls nicht mehr die Ausgänge des Ausgangsfrequenzteilers 8, da das Und-Gatter 30a für ihn zu spät freigegeben wird. Die Rückstellung des Zählers 34 durch den Ausgangsimpuls des Und-Gatters 29 bedingt, dass der $\overline{Q}_{12}$-Ausgang des Zählers 34 einen Logikwert "1" annimmt, der das Und-Gatter 33 freigibt. Sobald der Ausgangimpuls des Und-Gatters 29 beendet ist, beginnt der Zähler 34 die Impulse des rechteckförmigen Taktsignals T zu zählen. Wird der Zähler 34 in der Zwischenzeit nicht durch einen Ausgangsimpuls des Und-Gatters 29 auf Null zurückgestellt, dann zählt er solange, bis ein Logikwert "0" an seinem $\overline{Q}_{12}$-Ausgang erscheint, der einerseits das Flip Flop 28 auf Null zurückstellt und der anderseits das Und-Gatter 33 sperrt und damit den Zählvorgang des Zählers 34 beendet. Ein Logikwert "0" erscheint am $\overline{Q}_{12}$-Ausgang des Zählers 34 nach $2^{12-1} = 2^{11}$ Perioden der Dauer $128/f_R$ des Taktsignals T, d.h. nach $2^{18}/f_R$ Sekunden, was mit $f_R = {}^{10}$ Hz eine Dauer von $2^8 = 256$ Sekunden ergibt.

Die Leerlauf-Verhinderungsschaltung 28; 30a; 35 verhindert, dass ein nach längerer Zeit t, mit t > 256 Sekunden, am Ausgang $\overline{CO}$ des Zählers 25 erscheinender Impuls an die Ausgänge des Ausgangsfrequenzteilers 8 weitergegeben wird. Da nach 256 Sekunden das Flip Flop 28 durch das Ausgangssignal des Zählers 34 auf Null zurückgestellt wird, ist das Und-Gatter 30a für jeden ersten Impuls gesperrt. Im Normalbetrieb, wenn ein Signal $u_H$ am Eingang der Einrichtung ansteht, wird somit der erste am $\overline{Q}$-Ausgang des Flip Flops 26 erscheinende positive Impuls nicht an die Ausgänge des Ausgangsfrequenzteilers 8 weitergegeben (Anfangsfehler), jedoch seine negativgehende Flanke lädt einen Logikwert "1" in das Flip Flop 28, dessen Q-Ausgang damit das Und-Gatter 30a freigibt, und zwar für alle nachfolgenden Impulse. Letzteres ist bedingt durch die Tatsache, dass jeder neue Ausgangsimpuls des Und-Gatters 29 den Zäher 34 vor Ablauf von 256 Sekunden wieder auf Null zurückstellt. Dadurch wird der Zähler 34 immer wieder gezwungen, seinen Zählvorgang erneut bei Null zu beginnen, so dass nie ein Logikwert '0' an seinem $\overline{Q}_{12}$-Ausgang erscheint und somit auch nie das Flip Flop 28 auf Null zurückgestellt wird. Die Freigabe des Und-Gatters 30a dauert somit so lange an, bis kein Impuls mehr vor Ablauf der 256 Sekunden erscheint. Die mittlere Frequenz der Ausgangsimpulse des Zählers 25, des Flip Flops 26, des Und-Gatters 29 und des Und-Gatters 30a ist in diesem Fall proportional dem Signalstrom $i_H$ und damit auch proportional dem Signal $u_H$.

Im Leerlauf dagegen, wenn kein Signal $u_H$ an Eingang der Einrichtung ansteht, ist es möglich, dass die Integration von sehr kleinen Störsignalen über eine sehr sehr lange Zeit schliesslich auch einen Impuls am Ausgang des Und-Gatters 29 erzeugt. Dieser erreicht wie alle ersten Impulse die Ausgänge des Ausgangfrequenzteilers 8 nicht, da das Und-Gatter 30a gesperrt ist. Jedoch auch alle weitere Leerlauf-Impulse erreichen diese Ausgänge nicht, da ihr zeitlicher Abstand unter sich und zum ersten Impuls immer grösser als 256 Sekunden ist. D.h: Der Zähler 34 hat jedesmal, bevor er durch den Impuls auf Null zurückgestellt wird, genügend Zeit, um an seinem $\overline{Q}_{12}$-Ausgang einen Logikwert "0" erscheinen zu lassen, der jedesmal das Flip Flop 28 auf Null zurückstellt und damit jedesmal zeitig vor Erscheinen des nächsten Impulses des Und-Gatter 30a sperrt.

Das Ausgangssignal des Flip Flops 27 zeigt an, welche Polarität das Signal $u_H$ besitzt. Bei positiven Werten des Signals $u_H$ gibt es das Und-Gatter 30b frei, so dass das Ausgangssignal des Und-Gatters 30a als Signal M den Ausgang des Und-Gatters 30b erreicht. Bei negativen Werten des Signals $u_H$ gibt es dagegen das Und-Gatter 30c frei, so dass das Ausgangssignal des Und-Gatters 30a diesmal als Signal $M_1$ den Ausgang des Und-Gatters 30c erreicht.

Im Falle eines Elektrizitätszählers ist $u_H$ proportional $u_N \cdot i_L$, wobei $u_N$ die Netzspannung eines Energieversorgungsnetzes und $i_L$ ein Laststrom ist. Der in der Fig. 6 dargestellte Elektrizitätszähler besteht aus dem Polumschalter 1, einem Multiplikator 36, einer der bereits beschriebenen Schaltungen 2, einem fakultativ vorhandenen weiteren Frequenzteiler 37, einer Interfaceschaltung 38, einem Schrittmotor 39, einer Anzeige 40 und einer durch eine Leuchtdiode $D_1$ symbolisierten optischen Schnittstelle. Die Netzspannung $u_N$ erreicht jeweils zweipolig den Eingang des Polumschalters 1 und denjenigen Eingang der Schaltung 2, der von der Wechselsteuerspannung N gespeist werden soll. Eine dem Laststrom $i_L$ proportionale Spannung $u_L$ erreicht zweipolig einen ersten Eingang des Multiplikators 36, während der Ausgang des Polumschalters 1 zweipolig mit dessem zweiten Eingang verbunden ist. Der Ausgang des Multiplikators 36 ist zweipolig auf den Signaleingang der Schaltung 2 geführt, wobei ein Pol an Masse liegt.

Miteinander verbunden sind:

— Der Ausgang 22a der Schaltung 2 mit einem Takteingang des Frequenzteilers 37 und einem Rückstelleingang der Interfaceschaltung 38,

— der Ausgang 21 der Schaltung 2 mit einem Takteingang der Interfaceschaltung 38,

— der Ausgang des Frequenzteilers 37 mit einem Signaleingang der Interfaceschaltung 38 und

— der Ausgang der Schaltung 2, an dem das Umschaltsignal A bzw. B ansteht, mit dem Steuereingang des Polumschalters 1.

Ein zweipoliger Ausgang der Interfaceschaltung 38 ist mit den elektrischen Anschlüssen des Schrittmotors 39 verbunden, der die Anzeige 40 mechanisch antreibt. Ein zusätzlicher Ausgang der Interfaceschaltung 38 ist einpolig mit der Kathode der Leuchtdiode $D_1$ verbunden, dessen Anode an die positive Speisegleichspannung $V_{DD}$ liegt. Falls der Elektrizitätszähler nur positive Energie misst, ist der Signalausgang 22b der Schaltung 2 nicht anzuschliessen. Statt den Polumschalter 1, wie in der Fig. 6 dargestellt, dem Multiplikator 36 vorauszuschalten, kann er auch dem Multiplikator 36 nachgeschaltet sein. In beiden Fällen ist das Eingangssignal $\pm u_H$ der Schaltung 2 proportional dem Produkt $\pm u_N \cdot i_L$. Der Multiplikator 36 ist z.B. ein Hallelement. Der Frequenzteiler 37 ist z.B. programmierbar.

Der Polumschalter 1 wandelt gemäss der Fig. 6 die Netzspannung $u_N$ in die periodisch umgepolte Spannung $\pm u_N$ um, die im Multiplikator 36 mit der Spannung $u_L$ multipliziert wird, so dass am Eingang der Schaltung 2 eine Spannung $\pm u_H$ entsteht, die proportional dem Produkt $\pm u_N \cdot i_L$ und damit proportional der elektrischen Leistung ist. Die Spannung $\pm u_H$ wird in der Schaltung 2 integriert zur Bildung einer Ausgangsfrequenz, die proportional der elektrischen Leistung ist. Die Frequenz der am Ausgang 22a der Schaltung 2 erscheinenden rechteckförmigen Impulse wird fakultativ im Frequenzteiler 37 durch eine Zahl h geteilt, und die so erhaltenen rechteckförmigen Impulse werden zeit- und spannungsmässig in der nachfolgenden Interfaceschaltung 38 auf an sich bekannte Weise so aufbereitet, dass sie den Schrittmotor 39 steuern können. Beim Empfang eines jeden Impulses schaltet der Schrittmotor 39 um einen Schritt vorwärts. Nach einer vorgegebenen Anzahl Schritte, z.B. 300 Schritte, wird der von der Anzeige 40 angezeigte Wert um Eins inkrementiert. Statt einer elektromechanischen Anzeige 40 kann auch eine voll elektronische Leuchtdioden- oder Flüssigkristall-Anzeige verwendet werden. In diesem Fall können der Schrittmotor 39 und seine Interfaceschaltung 38 wegfallen und muss statt dessen ein zusätzlicher Frequenzteiler mit einem unverlierbaren Speicher verwendet werden. Die Leuchtdiode $D_1$ ihrerseits blinkt z.B. im Rhythmus der Impulse des Signals M und kann dazu benutzt werden, deren Impulsfrequenz optisch zu messen.

Der Eingangsteil der in der Fig. 1 dargestellten Schaltung 2 wird in einer bevorzugten monolytisch integrierten Ausführung wie in der Fig. 7 dargestellt aufgebaut. Insbesondere ist der Aufbau des Spannungs/Strom-Wandlers 3 und der Konstantstromquellen 10 und 15 im Detail dargestellt, während der Rest des Eingangsteils der Schaltung 2 nur angedeutet ist. Die beiden Konstantstromquellen 10 und 15 sowie im Spannungs/Strom-Wandler 3 enthaltene Stromquellen bestehen aus je einem Operationsverstärker, je einem Feldeffekttransistor und mindestens je einem Widerstand, wobei der Wert des Widerstandes jeweils den Wert des Ausgangsstromes der Stromquelle bestimmt. Der Aufbau derartiger Präzisions-Stromquellen ist an sich bekannt aus dem Buch Advanced Electronic Circuits, Tietze und Schenk, Springer Verlag, 1978, Seiten 57 bis 63. Drei der in der Fig. 7 verwendeten Konstantstromquellen benötigen eine gemeinsame Konstantspannungsquelle 41 von z.B. 1,235 Volt, deren positiver Pol an die positive Speisegleichspannung $V_{DD}$ liegt und deren negativer Pol mit je einem nichtinvertierenden Eingang der drei Operationsverstärker 42, 43 und 44 verbunden ist. Die Konstantstromquelle 10 besteht aus dem Operationsverstärker 42, dessen Ausgang auf einen Gate-Anschluss eines Feldeffekttransistors 45 geführt ist, während ein zweiter Anschluss des Feldeffekttransistors 45 direkt mit einem invertierenden Eingang des Operationsverstärkers 42 und über einen Widerstand 46 mit der positiven Speisegleichspannung $V_{DD}$ verbunden ist. Ein dritter Anschluss des Feldeffekttransistors 45 bildet den Ausgang der Konstantstromquelle 10 und liefert den Referenzstrom $I_R$. Der Ausgang der Konstantstromquelle 10 ist über den Umschalter 9 auf einen Ausgangspol des Polumschalters 5 sowie auf einen Pol des Kondensators C geführt. Die Konstantstromquelle 15 besteht aus dem Operationsverstärker 43, einem Feldeffekttransistor 47 und einem Widerstand 48. Der Spannungs/Strom-Wandler 3 enthält eine Konstantstromquelle 49 und zwei Stromquellen 50 und 51. Die Konstantstromquelle 49 besteht aus dem Operationsverstärker 44, einem Feldeffekttransistor 52 und einem Widerstand 53. Die Stromquelle 50 ist aus einem Operationsverstärker 54, einem Feldeffekttransistor 55 und einem Widerstand 56 zusammengesetzt, während die Stromquelle 51 ihrerseits aus einem Operationsverstärker 57, einem Feldeffekttransistor 58 und einem Widerstand 59 besteht. Der Aufbau aller Stromquellen 15, 49, 50 und 51 ist identisch wie derjenige der Konstantstromquelle 10, allerdings ist der zweite Anschluss des Feldeffekttransistors 55 über den Widerstand 56 nicht mit der positiven Speisgleichspannung $V_{DD}$, sondern mit Masse und derjenige des Feldeffekttransistors 58 über den Widerstand 59 mit der negativen Speisegleichspannung $-|V_{SS}|$ verbunden, statt mit der positiven Speisegleichspannung $V_{DD}$. Der nicht an Masse liegende Eingangspol der Schaltung 2 und der Ausgang der Konstantstromquelle 49 sind jeweils auf einen nichtinvertierenden Eingang des Operationsverstärkers 54 bzw. 57 geführt. Der nichtinvertierende Eingang des Operationsverstärkers 57 liegt ausserdem über einen Widerstand 60 an der negativen Speisegleichspannung $-|V_{SS}|$. Der Ausgang der Konstantstromquelle 15 liefert den halben Referenzstrom $I_R/2$ und ist mit dem invertierenden Eingang des Operationsverstärkers 54 verbunden, während der Ausgang der Stromquelle 50 auf den invertierenden Eingang des Operationsverstärkers 57 geführt ist. Die Stromquelle 50 arbeitet als Spannungs/Strom-Wandler, der das als Spannung anstehende Signal $\pm u_H$ in einen proportionaleen Strom $\pm i_H$ umwandelt, der im Widerstand 56 fliesst und im Feldeffekttransistor 55 vom halben Referenzstrom $I_R/2$, der von der Konstantstromquelle 15 geliefert wird, substrahiert wird. Dieser Differenzstrom $I_R/2 \mp i_H$ am Ausgang der Stromquelle 50 wird in der Stromquelle 51, die im Widerstand 59 den Referenzstrom $I_R$ erzeugt, von diesem Referenzstrom $I_R$ subtrahiert, so dass am Ausgang der Stromquelle 51 und damit auch am Ausgang des Spannungs/Strom-Wandlers 3 der geforderte Strom $\pm i_H + I_R/2$ entsteht. Der Ausgang der Stromquelle 51 und die Masse bilden zusammen den zweipoligen Ausgang des Spannungs/Strom-Wandlers 3 und sind mit dem zweipoligen Eingang des Polumschalters 5 verbunden.

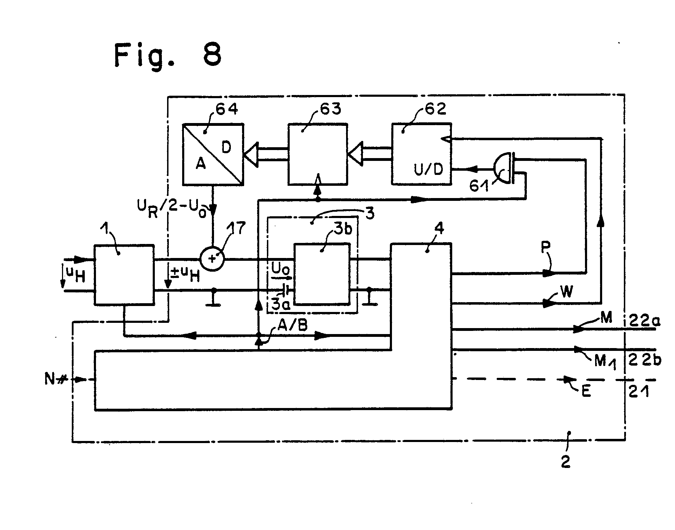

Die in der Fig. 8 dargestellte vierte Variante der Einrichtung ist annähernd gleich aufgebaut wie die in der Fig. 2 dargestellte zweite Variante, nur dass die Konstantspannungsquelle 16 durch einen Regler 61; 62; 63; 64 als Spannungsquelle ersetzt ist. Die Ausgangsspannung $U_R/2 - U_o$ des Reglers 61; 62; 63; 64 ersetzt dabei das Referenzsignal $U_R/2$ der Konstantspannungsquelle 16 und ist gleich der um die Nullspannung $U_o$ des Spannungs/Strom-Wandlers 3 reduzierten Referenzspannung $U_R/2$. Der Regler 61; 62; 63; 64 besteht aus einem Exklusiv-Oder Gatter 61, einem Vorwärts/Rückwärts-Zähler 62, einem Zwischenspeicher 63 und einem Digital/Analog-Wandler 64, die in der angegebenen Reihenfolge in Kaskade geschaltet sind, wobei zwischen dem Vorwärts/Rückwärts-Zähler 62 und dem Zwischenspeicher 63 einerseits und zwischen dem Zwischenspeicher 63 und dem Digital/Analog-Wandler 64 anderseits je eine Datenbus-Verbindung vorhanden ist. Der Ausgang der Schaltung 4, an dem das Umschaltsignal A bzw. B ansteht, ist mit einem ersten Eingang des Exklusiv-Oder-Gatters 61 und mit einem Takteingang des Zwischenspeichers 63 verbunden. Die in der Schaltung 4 vorhandenen Signale W und P (siehe Fig. 1) sind bei dieser vierten Variante zusätzlich auf einen Takteingang des Vorwärts/Rückwärts-Zählers 62 bzw. auf einen zweiten Eingang des Exklusiv-Oder-Gatters 61 geführt (siehe Fig. 8). Der Ausgang des Exklusiv-Oder-Gatters 61 ist mit einem "Up/Down"-Eingang U/D des Vorwärts/Rückwärts-Zählers 62 verbunden.

In der zweiten Variante wird nur der Mittelwert des Einflusses der Nullspannung $U_o$ auf die Ausgangsfrequenz der Einrichtung annulliert. In der vierten Variante wird dagegen noch zusätzlich eine durch die Nullspannung $U_o$ verursachte Frequenzmodulation der Ausgangssignale M und $M_1$ der Einrichtung eliminiert. Der Vorwärts/Rückwärts-Zähler 62 (siehe Fig. 8) arbeitet ähnlich wie der Zähler 25 im Ausgangsfrequenzteiler 8 (siehe Fig. 5) mit dem Unterschied, dass die Zählrichtung des Vorwärts/Rückwärts-Zählers 62, dank des Vorhandenseins des Exklusiv-Oder-Gatters 61, während der geradzahligen Halbperioden umgekehrt ist von derjenigen, die während der ungeradzahligen Halbperioden des Umschaltsignals A bzw. B gilt. Während einer ungeradzahliger Halbperiode ergibt die Zählung des Vorwärts/Rückwärts-Zählers 62 einen Zählwert $(f_H + f_o) \cdot T/2$ und während einer geradzahligen Halbperiode einen Zählwert $-(f_H - f_o) \cdot T/2$, so dass während einer ganzen Periode T des Umschaltsignals A bzw. B ein Zählwert

$$(f_H + f_o) \cdot T/2 - (f_H - f_o) \cdot T/2 = 2f_o \cdot T/2 = f_o \cdot T$$

ermittelt wird. Dabei ist $f_H$ der Anteil der Frequenz $f_F$, der dem Signal $u_H$ entspricht, und $f_o$ der Anteil der Frequenz $f_F$, der der Nullspannung $U_o$ entspricht. Der Zählwert $f_o \cdot T$ ist somit proportional der Nullspannung $U_o$. Er wird am Ende einer jeden Periode T mit den positionsgehenden Flanken des Umschaltsignals A bzw. B in den Zwischenspeicher 63 geladen, um anschliessend mit Hilfe des Digital/Analog-Wandlers 64 in einen Analogwert umgewandelt zu werden. Im eingeschwungenen Zustand des Regelkreises 17; 3; 4; 61; 62; 63; 64 ist dieser Analogwert am Ausgang des Digital/Analog-Wandlers 64 gleich $U_R/2 - U_o$. Der Analogausgang des Digital/Analog-Wandlers 64 ist mit dem ersten Eingang des Addiergliedes 17 verbunden. Der Ausgangsstrom des Spannungs/Strom-Wandlers 3 ist somit wie gefordert proportional der Summenspannung

$$\pm u_H + U_R/2 - U_o + U_o = \pm u_H + U_R/2,$$

wobei die zweite Nullspannung $U_o$ durch den Spannungs/Strom-Wandler 3 in die Schaltung eingeführt wird. Im Ausgangsstrom des Spannungs/Strom-Wandlers 3 ist somit ideal kein Anteil der Nullspannung $U_o$ mehr vorhanden.

**Patentansprüche**

1. Verfahren zur Umwandlung eines elektrischen Signals ($u_H$) in eine proportionale Frequenz ($f_F$) mit einer periodischen Umpolung des Signals ($u_H$), einer Integration des periodisch umgepolten Signals ($\pm u_H$) in einem Kondensator (C), eine Überwachung des so erhaltenen integrierten Signals zwecks Steuerung des Zu- und Abschaltens eines konstanten Referenzstroms ($I_R$) bei Über- bzw. Unterschreitung eines Schwellwerts unter gleichzeitiger Erzeugung rechteckförmiger Ausgangsimpulse, wobei der zugeschaltete Referenzstrom ($I_R$) dem Kondensator (C) jeweils eine konstante Ladungsmenge (Q) entzieht oder zuführt, dadurch gekennzeichnet, daß vor der Integration zu einem dem periodisch umgepolten Signal ($\pm u_H$) proportionalen Signal ($\pm u_H$, $\pm i_H$) ein konstantes Referenzsignal ($U_R/2$, $I_R/2$) addiert wird, dessen Wert dem halben Wert des Referenzstroms (I) entspricht, daß nachfolgend ein dem so erhaltenen Summensignal ($\pm u_H + U_R/2$, $\pm i_H + I_R/2$) proportionales Stromsignal ($\pm i_H + I_R/2$), synchron zur periodischen Umpolung des Signals ($u_H$), ebenfalls periodisch umgepolt wird, um dann integriert zu werden, und daß von der Frequenz der so erzeugten rechteckförmigen Ausgangsimpulse anschließend noch eine konstante Referenzfrequenz ($f_R/2$), die dem Wert des Referenzsignals ($U_R/2$, $I_R/2$) entspricht, subtrahiert wird.

2. Verfahren nach Anspruch 1, dadurch gekennzeichnet, dass das Referenzsignal ($U_R/2$) eine Gleichspannung ist, die zum periodisch umgepolten Signal ($\pm u_H$) addiert wird, und dass durch eine nachfolgende Spannungs/Strom-Wandlung das Summensignal ($\pm u_H + U_R/2$) in ein proportionales Stromsignal ($\pm i_H + I_R/2$) umgewandelt wird.

3. Verfahren nach Anspruch 2, dadurch gekennzeichnet, dass die Gleichspannung eine um eine Nullspannung ($U_o$) eines Spannungs/Strom-Wandlers (3) reduzierte Spannung ($U_R/2 - U_o$) ist.

4. Verfahren nach Anspruch 1, dadurch gekennzeichnet, dass das Referenzsignal ($I_R/2$) ein Gleichstrom ist, der nach einer Spannungs/Strom-Wandlung des periodisch umgepolten Signals ($\pm u_H$) zum so erzeugten proportionalen Stromsignal ($\pm i_H$) addiert wird zwecks Bildung des einem Summensignal ($\pm u_H + U_R/2$) proportionalen Stromsignals ($\pm i_H + I_R/2$).

5. Verfahren nach einem der Ansprüche 1 bis 4, dadurch gekennzeichnet, dass das periodisch umgepolte Signal ($\pm u_H$) wechselspannungsmässig verstärkt wird, bevor es weiter verarbeitet wird.

6. Verfahren nach einem der Ansprüche 1 bis 5, dadurch gekennzeichnet, dass die Referenzfrequenz ($f_R/2$) die Frequenz eines Taktsignals (P) rechteckförmiger Impulse ist.

7. Einrichtung zur Durchführung des Verfahrens nach einem der Ansprüche 1 bis 6, mit mindestens einem ersten Polumschalter (1), einem nachgeschalteten Integrator (3;C), der den Kondensator (C) enthält, einem dem Integrator (3;C) zur Ueberwachung des integrierten Signals ($u_c$) nachgeschalteten Komparator (6), einem dem Komparator (6) nachgeschalteten Flip Flop (7), einem vom Flip Flop (7) gesteuerten Umschalter (9), der dem Zu- und Abschalten des Referenzstromes ($I_R$) dient, einer Konstantstromquelle (10), die den Referenzstrom ($I_R$) liefert, einer Steuerschaltung (13; 14 bzw. 11; 12) zur Erzeugung eines periodischen Umschaltsignals (A bzw. B) für den Polumschalter (1) und einer Signalquelle (16, 61; 62; 63; 64, 15), dadurch gekennzeichnet, dass die Signalquelle (16, 61; 62; 63; 64, 15) im Eingangsteil des Integrators (3;C) angeordnet ist und zur Erzeugung des Referenzsignals ($U_R/2$, $U_R/2 - U_o$, $I_R/2$) dient, dass ein zweiter Polumschalter (5), der vom gleichen Umschaltsignal (A, B) gesteuert ist wie der erste Polumschalter (1), zwischen einem im Integrator (3;C) enthaltenen Spannungs/Strom-Wandler (3) und dem Kondensator (C) angeordnet ist, und dass am Ausgang der Einrichtung ein Vorwärts/Rückwärts-Zähler vorhanden ist zur Subtraktion der konstanten Referenzfrequenz ($f_R/2$).

8. Einrichtung nach Anspruch 7, dadurch gekennzeichnet, dass die Signalquelle (15, 16) eine Spannungsquelle ist und mit einem Addiergleid (17) am Eingang des Spannungs/Strom-Wandlers (3) vorhanden ist.

9. Einrichtung nach Anspruch 8, dadurch gekennzeichnet, dass die Spannungsquelle eine Konstantspannungsquelle (16) ist.

10. Einrichtung nach Anspruch 8, dadurch gekennzeichnet, dass die Spannungsquelle ein Regler (61; 62; 63; 64) ist, der aus einem Exklusiv-Oder-Gatter (61), einem Vorwärts/Rückwärts-Zähler (62), einem Zwischenspeicher (63) und einem Digital-Analog-Wandler (64) besteht.

11. Einrichtung nach Anspruch 7, dadurch gekennzeichnet, dass die Signalquelle (15) eine Konstantstromquelle ist und am Ausgang des Spannungs/Strom-Wandlers (3) vorhanden ist.

12. Einrichtung nach einem der Ansprüche 7 bis 11, dadurch gekennzeichnet, dass zwischen dem ersten Polumschalter (1) und dem Spannungs/Strom-Wandler (3) ein Hochpassverstärker (18) geschaltet ist.

13. Einrichtung nach Anspruch 12, dadurch gekennzeichnet, dass der Hochpassverstärker (18) aus einem Verstärker (19) und einem nachgeschalteten Hochpassfilter (20) besteht.

14. Einrichtung nach einem der Ansprüche 7 bis 13, dadurch gekennzeichnet, dass der Ausgangsfrequenzteiler (8) mindestens ein Exklusiv-Oder-Gatter (23), einen Zähler (25), zwei Flip Flop (26, 27) und zwei Und-Gatter (24, 29) enthält, wobei der Zähler (25) ein Vorwärts/Rückwärts-Zähler ist.

15. Einrichtung nach Anspruch 14, dadurch gekennzeichnet, dass der Ausgangsfrequenzteiler (8) eine Leerlauf-Verhinderungsschaltung (28; 30a; 35) enthält.

16. Einrichtung nach Anspruch 15, dadurch gekennzeichnet, dass die Leerlauf-Verhinderungsschaltung (28; 30a, 35) aus einem monostabilen Multivibrator (35), einem Flip Flop (28) und einem Und-Gatter (30) besteht.

17. Einrichtung nach Anspruch 16, dadurch gekennzeichnet, dass der monostabile Multivibrator (35) aus einem Und-Gatter (33) und einem Zähler (34) besteht.

18. Einrichtung nach einem der Ansprüche 7 bis 17, dadurch gekennzeichnet, dass der Spannungs/Strom-Wandler (3) drei Stromquellen (49, 50, 51) enthält.

19. Einrichtung nach einem der Ansprüche 7 bis 18, dadurch gekennzeichnet, dass jede Stromquelle (10, 15, 49, 50, 51) aus einem Operationsverstärker (42, 43, 44, 54, 57), einem Feldeffekttransistor (45, 47, 52, 55, 58) und mindestens einem Widerstand (46, 48, 53, 56, 59) besteht.

20. Elektrizitätszähler mit einer Einrichtung nach einem der Ansprüche 7 bis 19.

## Revendications

1. Procédé pour convertir un signal électrique ($u_H$) en une fréquence proportionnelle ($f_F$), moyennant une inversion périodique de la polarité du signal ($u_H$), une intégration du signal ($\pm u_H$) dont la polarité est inversée périodiquement, dans un condensateur (C), un contrôle du signal intégré ainsi obtenu pour réaliser la commande de l'application et de l'interruption d'un courant de référence constant ($I_R$) lors du dépassement par valeurs supérieure ou inférieure d'une valeur de seuil, moyennant la production simultanée d'impulsions de sortie rectangulaires, le courant de référence ($I_R$) appliqué prélevant du condensateur (C) ou envoyant à ce dernier respectivement une quantité de charges constante (Q), caractérisé en ce qu'avant l'intégration permettant d'obtenir un signal ($\pm u_H$) proportionnel au signal ($\pm u_H$), dont la polarité est inversée périodiquement, on ajoute un signal de référence constant ($U_R/2$, $I_R/2$), dont la valeur correspond à la moitié de la valeur du courant de référence (I), qu'ensuite on inverse également périodiquement la polarité d'un signal de courant ($\pm i_H + i_H/2$), proportionnel au signal somme ($\pm u_H + U_R/2$, $\pm i_H + I_R/2$), ainsi obtenu, et ce en synchronisme avec l'inversion périodique de la polarité du signal ($u_H$), puis on l'intègre, et qu'ensuite on soustrait en outre, de la fréquence des impulsions de sortie rectangulaires ainsi produites, une fréquence de référence constante ($f_R/2$), qui correspond à la valeur du signal de référence ($U_R/2$, $I_R/2$).

2. Procédé selon la revendication 1, caractérisé en ce que le signal de référence ($U_R/2$) est une tension continue, que l'on ajoute au signal ($\pm u_H$), dont la polarité est inversée périodiquement, et que le signal somme ($\pm u_H + U_R/2$) est converti en un signal de courant proportionnel ($\pm i_H + I_R/2$), au moyen d'une conversion tension/courant exécutée en aval.

3. Procédé selon la revendication 2, caractérisé en ce que la tension continue est une tension ($U_R/2 - U_o$), réduite d'une tension de zéro ($U_o$) d'un convertisseur tension/courant (3).

4. Procédé selon la revendication 1, caractérisé en ce que le signal de référence ($I_R/2$) est un courant continu, qui est ajouté, après une conversion tension/courant du signal ($\pm u_H$), dont la polarité est inversée périodiquement, au signal de courant proportionnel ($\pm u_H$) ainsi obtenu, au moyen de la formation du signal de courant ($\pm i_H + I_R/2$) proportionnel à un signal somme ($\pm u_H + I_R/2$).

5. Procédé selon l'une des revendications 1 à 4, caractérisé en ce que le signal ($\pm u_H$), dont la polarité est inversée périodiquement, est amplifié d'une manière rapportée à la tension alternative, avant que son traitement soit poursuivi.

6. Procédé selon l'une des revendications 1 à 5, caractérisé en ce que la fréquence de référence ($f_R/2$) est la fréquence d'un signal de cadence (P) formé d'impulsions rectangulaires.

7. Dispositif pour la mise en oeuvre du procédé selon l'une des revendications 1 à 6, comportant au moins un premier inverseur de polarité (1), un intégrateur (3;C) branché en aval, qui contient le condensateur (C), un comparateur (6) branché en aval de l'intégrateur (3;C) pour contrôler le signal intégré ($u_c$), une bascule bistable (7) branchée en aval du comparateur (6), un commutateur (9) commandé par la bascule bistable (7) et servant à appliquer et interrompre le courant de référence ($I_R$), et une source de courant constant (10), qui délivre le courant de référence ($I_R$), un circuit de commande (13; 14) ou (11; 12) servant à produire un signal d'inversion périodique (A ou B) pour l'inverseur de polarité (1), et une source de signaux (16, 61; 62; 63; 64, 15), caractérisé en ce que la source de signaux (16, 61; 62; 63; 64, 15) est situé dans la partie d'entrée de l'intégration (3;C) et sert à produire le signal de référence ($U_R/2$, $U_R/2 - U_o$, $I_R/2$), et un second inverseur de polarité (5), qui est commandé par le même signal d'inversion (A, B) que le premier inverseur de polarité (1), est disposé entre un convertisseur tension/courant (3) présent dans l'intégrateur (3;C) et le condensateur (C), et qu'un compteur progressif/régressif est branché à la sortie du dispositif pour soustraire la fréquence de référence constant ($f_R/2$).

8. Dispositif selon la revendication 7, caractérisé en ce que la source de signaux (15, 16) est une source de tension et est présente, ainsi qu'un circuit additionneur (17), à l'entrée du convertisseur tension/courant (3).

9. Dispositif selon la revendication 8, caractérisé en ce que la source de tension est une source de tension constante (16).

10. Dispositif selon la revendication 8, caractérisé en ce que la source de tension est un régulateur (61; 62; 63; 64), qui est constitué par une port OU-Exclusif (61), un compteur progressif/régressif (62), une mémoire intermédiaire (63) et un convertisseur numérique/analogique (64).

11. Dispositif selon la revendication 7, caractérisé en ce que la source de signaux (15) est une source de courant constant et est présente à la sortie du convertisseur tension/courant (3).

12. Dispositif selon l'une des revendications 7 à 11, caractérisé en ce qu'un amplificateur passe-haut (18) est branché entre le premier inverseur de polarité (1) et le convertisseur tension/courant (3).

13. Dispositif selon la revendication 12, caractérisé en ce que l'amplificateur passe-haut (18) est constitué par un amplificateur (19) et par un filtre passe-haut (20) branché en aval.

14. Dispositif selon l'une des revendications 7 à 13, caractérisé en ce que le diviseur (8) de la fréquence de sortie contient au moins une porte OU-Exclusif (23), un compteur (25), deux bascules bistables (26, 27) et deux portes ET (24, 29), le compteur (25) étant un compteur progressif/régressif.

15. Dispositif selon la revendication 14, caractérisé en ce que le diviseur (8) de la fréquence de sortie contient un circuit (28; 30a; 35) empêchant un fonctionnement à vide.

16. Dispositif selon la revendication 15, caractérisé en ce que le circuit (28; 30a; 35) empêchant la fonctionnement à vide est constitué par un multivibrateur monostable (35), une bascule bistable (28) et une porte ET (30).

17. Dispositif selon la revendication 16, caractérisé en ce que le multivibrateur monostable (35) est constitué par une porte ET (33) et par un compteur (34).

18. Dispositif selon l'une des revendications 7 à 17, caractérisé en ce que le convertisseur tension/courant (3) contient trois sources de courant (49, 50, 51).

19. Dispositif selon l'une des revendications 7 à 18, caractérisé en ce que chaque source de courant (10, 15, 29, 50, 51) est constituée par un amplificateur opérationnel (42, 43, 44, 54, 57), par un transistor à effet de champ (45, 47, 52, 55, 58) et par au moins une résistance (46, 48, 53, 56, 59).

20. Compteur d'électricité comportant un dispositif selon l'une des revendications 7 à 19.

**Claims**

1. A process for converting an electrical signal ($u_H$) into a proportional frequency ($f_F$) with periodic pole reversal of the signal ($u_H$), integration of the periodically pole-reversed signal ($\pm u_H$) in a capacitor (C), monitoring of the resulting integrated signal for the purposes of controlling the switching on and off of a constant reference current when rising above or falling below a threshold value, with the simultaneous generation of rectangular output pulses, wherein the reference current ($I_R$) when switched on removes or feeds a constant charge quantity (Q) from or to the capacitor (C), characterised in that prior to the integration operation a constant reference signal ($U_R/2$, $I_R/2$) is added to a signal ($\pm u_H$, $\pm i_H$) which is proportional to the periodically pole-reversed signal ($\pm u_H$), the value of said constant reference signal corresponding to half the value of the reference current ($I_R$), that subsequently a current signal ($\pm i_H + I_R/2$) which is proportional to the resulting sum signal ($\pm u_H + U_R/2$, $\pm i_H + I_R/2$) is also periodically reversed in polarity synchronously with respect to the periodic pole reversal of the signal ($u_H$), in order then to be integrated, and that there is then also subtracted from the frequency of the resulting rectangular output pulses, a constant reference frequency ($f_R/2$) which corresponds to the value of the reference signal ($U_R/2$, $I_R/2$).

2. A process according to claim 1 characterised in that the reference signal ($U_R/2$) is a d.c. voltage which is added to the periodically polarity-reversed signal ($\pm u_H$) and that the sum signal ($\pm u_H + U_R/2$) is converted into a proportional current signal ($\pm i_H + I_R/2$) by a subsequent voltage-current conversion step.

3. A process according to claim 2 characterised in that the d.c. voltage is a voltage ($U_R/2 - U_o$) reduced by a zero voltage ($U_o$) of a voltage-current converter (3).

4. A process according to claim 1 characterised in that the reference signal ($I_R/2$) is a direct current which, after voltage-current conversion of the periodically polarity-reversed signal ($\pm u_H$) is added to the resulting proportional current signal ($\pm i_H$), for the purposes of forming the current signal ($\pm i_H + I_R/2$) which is proportional to the sum signal ($\pm u_H + U_R/2$).

5. A process according to one of claims 1 to 4 characterised in that the periodically polarity-reversed signal ($\pm u_H$) is amplified in respect of a.c. voltage, before it is subjected to further processing.

6. A process according to one of claims 1 to 5 characterised in that the reference frequency ($f_R/2$) is the frequency of a clock signal (P) of rectangular pulses.

7. Apparatus for carrying out the process according to one of claims 1 to 6 comprising at least a first pole changing switch (1), an integrator (3, C) on the output side thereof and including the capacitor (C), a comparator (6) on the output side of the integrator (3, C) for monitoring the integrated signal ($u_C$), a flip-flop (7) on the output side of the comparator (6), a change-over switch (9) controlled by the flip-flop (7) for switching the reference current ($I_R$) on and off, a constant current source (10) which delivers the reference current ($I_R$), a control circuit (13, 14, and 11, 12 respectively) for producing a periodic change-over signal (A, B) for the pole changing switch (1) and a signal source (16, 61, 62, 63, 64, 15) characterised in that the signal source (16, 61, 62, 63, 64, 15) is arranged in the input portion of the integrator (3, C) and serves to generate the reference signal ($U_R/2$, $U_R/2 - U_o$, $I_R/2$), that a second pole changing switch (5) which is controlled by the same change-over signal (A, B) as the first pole changing switch (1) is arranged between a voltage-current converter (3) contained in the integrator (3, C) and the capacitor (C), and that provided at the output of the apparatus is an up-down counter for subtraction of the constant reference frequency ($f_R/2$).

8. Apparatus according to claim 7 characterised in that the signal source (15, 16) is a voltage source and is provided with an adding member (17) at the input of the voltage-current converter (3).

9. Apparatus according to claim 8 characterised in that the voltage source is a constant voltage source (16).

10. Apparatus according to claim 8 characterised in that the voltage source is a regulator (61, 62, 63, 64) which comprises an exclusive or gate (61), an up-down counter (62), an intermediate storage means (63) and a digital-analog converter (64).

11. Apparatus according to claim 7 characterised in that the signal source (15) is a constant current source and is provided at the output of the voltage-current converter (3).

12. Apparatus according to one of claims 7 to 11 characterised in that a high pass amplifier (18) is connected between the first pole changing switch (1) and the voltage-current converter (3).

13. Apparatus according to claim 12 characterised in that the high pass amplifier (18) comprises an amplifier (19) and a high pass filter (20) on the output side thereof.

14. Apparatus according to one of claims 7 to 13 characterised in that the output frequency divider (8) includes at least an exclusive or gate (23), a counter (25), two flip-flops (26, 27) and two and gates (24, 29), the counter (25) being an up-down counter.

15. Apparatus according to claim 14 characterised in that the output frequency divider (8) includes a no-load inhibition circuit (28, 30a, 35).

16. Apparatus according to claim 15 characterised in that the no-load inhibition circuit (28, 30a, 35) comprises a monostable multivibrator (35), a flip-flop (28) and an and gate (30).

17. Apparatus according to claim 16 characterised in that the monostable multivibrator (35) comprises an and gate (33) and a counter (34).

18. Apparatus according to one of claims 7 to 17 characterised in that the voltage-current converter (3) includes three current sources (49, 50, 51).

19. Apparatus according to one of claims 7 to 18 characterised in that each current source (10, 15, 49, 50, 51) comprises an operational amplifier (42, 43, 44, 54, 57), a field effect transistor (45, 47, 52, 55, 58) and at least one resistor (46, 48, 53, 56, 59).

20. An electricity meter comprising an apparatus according to one of claims 7 to 19.

Fig. 1

Fig. 2

# Fig. 3

# Fig. 4

# Fig. 5

# Fig. 6

# Fig. 7

# Fig. 8